# EUROPÄISCHE PATENTANMELDUNG

(11) **EP 2 112 412 A1**
(43) Veröffentlichungstag der Anmeldung: **28.10.2009**
(21) Anmeldenummer: 09100224.6
(22) Anmeldetag: 06.04.2009
(51) Int. Cl.: F16K 31/00, H01L 41/00

(54) **Absperrorgan**

(30) Priorität: 25.04.2008 DE 102008001386
(71) Anmelder: ROBERT BOSCH GMBH, 70442 Stuttgart (DE)
(72) Erfinder: Hagemann, Benjamin, 70839 Gerlingen (DE); Schmidt, Ralf, 70839 Gerlingen (DE); Bolz, Martin-Peter, 77815 Bühl (DE)

(57) **Zusammenfassung**

Absperrorgan mit einem Sperrkörper (1) und einem Schließelement (2'), wobei das Schließelement (2') einen elektroaktiven Werkstoff (19) und zwei Elektroden (10, 21) umfasst, um den elektroaktiven Werkstoff (19) durch Anlegen geeigneter Spannungen zwischen einem Schließzustand und einem Öffnungszustand zu verformen. Um ein Absperrorgan zu schaffen, welches insbesondere eine einfache Struktur hat, umgibt das Schließelement (2') zumindest einen Teil des Umfangs des Sperrkörpers (1), ist in dem Öffnungszustand ein Spalt zwischen dem Sperrkörper (1) und dem Schließelement (2') ausgebildet, und ist in dem Schließzustand der Spalt (16) zwischen dem Sperrkörper (1) und dem Schließelement (2') verschlossen.

## Beschreibung

### Stand der Technik

Die vorliegende Erfindung betrifft ein Absperrorgan gemäß dem Oberbegriff des Patentanspruchs 1 und ein Verfahren zum Herstellen eines Absperrorgans gemäß dem Oberbegriff des Patentanspruchs 12.

Eine solches Absperrorgan ist aus der WO2006/020093 bekannt und weist einen Sperrkörper und ein Schließelement auf, wobei das Schließelement einen elektroaktiven Werkstoff und zwei Elektroden umfasst, um den elektroaktiven Werkstoff durch Anlegen geeigneter Spannungen zwischen einem Schließzustand und einem Öffnungszustand zu verformen. Der elektroaktive Werkstoff ist elektrisch isolierend. Das Schließelement ist in einem Hohlraum in dem Sperrkörper aufgenommen. In dem Sperrkörper ist außerdem eine Fluidleitung ausgebildet. Das Schließelement ragt mit einem Ende in die Fluidleitung herein. Die Elektroden sind auf zwei gegenüberliegenden Seiten des elektroaktiven Werkstoffs angeordnet, der als eine Platte ausgebildet ist. Wenn an die zwei Elektroden entgegen gesetzte Spannungen angelegt werden, wird die Platte zusammengedrückt, so dass sich ihre Dicke verringert und gleichzeitig ihre Länge zunimmt. Das Schließelement ragt dann weiter in die Fluidleitung herein und sperrt den Durchfluss eines Fluids durch die Fluidleitung ab.

Ein Nachteil eines solchen Absperrorgans liegt darin, dass es eine komplexe Struktur hat, und dass dessen Herstellung daher einen großen Aufwand erfordert. Ein weiterer Nachteil eines solchen Absperrorgans liegt darin, dass die absperrbare Durchflussfläche relativ gering ist, und es daher nicht für größere Durchflussmengen geeignet ist. Außerdem kann ein solches Absperrorgan keinem hohen Druck widerstehen, da das Schließelement ein elektroaktives und somit elastisches Material umfasst, welches nur in einem kleinen Bereich durch die elastische Kraft dem Druck des Fluids entgegenwirkt.

### Offenbarung der Erfindung

Der vorliegenden Erfindung liegt die Aufgabe zugrunde, ein Absperrorgan und ein Verfahren zur Herstellung eines Absperrorgans zu schaffen, welches zumindest einige der obigen Nachteile nicht aufweist.

Die der Erfindung zugrunde liegende Aufgabe wird durch ein Absperrorgan mit den Merkmalen des kennzeichnenden Teils Patentanspruchs 1 und ein Verfahren zur Herstellung eines Absperrorgans mit den Merkmalen des kennzeichnenden Teils Patentanspruchs 12 gelöst.

Die vorliegende Erfindung betrifft ein Absperrorgan, wobei das Schließelement zumindest einen Teil des Umfangs des Sperrkörpers umgibt, wobei in dem Öffnungszustand ein Spalt zwischen dem Sperrkörper und dem Schließelement ausgebildet ist, und wobei in dem Schließzustand der Spalt zwischen dem Sperrkörper und dem Schließelement verschlossen ist. Der Spalt zwischen dem Sperrkörper und dem Schließelement kann dabei sehr lang ausgebildet sein, so dass pro Längeneinheit des Spalts in dem Schließzustand nur ein geringer Druck abfällt und das Absperrorgan besonders dich ausgebildet werden kann. Das Absperrorgan ist zudem leicht, lautlos und benötigt wenig Bauraum.

In einer bevorzugten Ausführungsform ist der zumindest eine Teil des Umfangs des Sperrkörpers ein elliptischer, vorzugsweise kreisförmiger Umfangsabschnitt. Ein solches Absperrorgan kann besonders einfach und wirkungsvoll ausgestaltet werden. Vorzugsweise hat der gesamte Sperrkörper einen elliptischen oder kreisförmigen Umfangsabschnitt.

In einer Weiterbildung der bevorzugten Ausführungsform ist der elektroaktive Werkstoff als eine Folie mit einer Dicke zwischen 4 µm und 250 µm, vorzugsweise zwischen 4 µm und 100 µm, ausgebildet, und sind die zwei Elektroden auf gegenüberliegenden Seiten der Folie flächig angeordnet. Die Verwendung einer möglichst dünnen Folie ermöglicht es, diese für relativ geringe Spannungsdifferenzen an den zwei Elektroden maximal zu verformen.

In noch einer Weiterbildung der bevorzugten Ausführungsform weist das Schließelement eine weitere Folie aus elektroaktivem Werkstoff auf, ist eine der zwei Elektroden flächig zwischen der Folie und der weitern Folie angeordnet, sind die Folie und die weitere Folie um den Abschnitt des Sperrkörpers gewickelt, und bilden die Folie und die weitere Folie einen Schlauch, in dem der Abschnitt des Sperrkörpers aufgenommen ist. Ein solches Absperrorgan lässt sich mit geringem Aufwand fertigen und ist somit kostengünstig. Dadurch dass die Folien mehrfach um den Sperrkörper gewickelt werden, lässt sich die Anpresskraft der Folien an den Sperrkörper erhöhen, und lässt sich eine besonders hohe Dichtigkeit des Absperrorgans erreichen. Das Schließelement kann eine schlauchförmige Folie umfassen, welche den Sperrkörper umgibt. Dadurch lässt sich eine noch höhere Dichtigkeit des Absperrorgans erreichen. Außerdem sind nur zwei Anschlüsse für die ebenfalls zwei Elektroden erforderlich, so dass der Aufbau nicht kompliziert ist.

In einer alternativen Weiterbildung der bevorzugten Ausführungsform weist das Schließelement mehrere weitere Folien aus elektroaktivem Werkstoff auf, ist zwischen benachbarten Folien jeweils eine Elektrode flächig angeordnet, sind die Folie und die weitere Folie schlauchförmig ausgebildet und bilden einen mehrlagigen Schlauch, in dem der Abschnitt des Schließelements aufgenommen ist. Ein solches Absperrorgan weist eine besonders hohe Dichtigkeit auf.

In noch einer Weiterbildung der bevorzugten Ausführungsform weist das Schließelement einen Umfangsabschnitt auf, in dem keine Elektrode ausgebildet ist, weist der Sperrkörper einen Hohlraum auf, münden eine erste Öffnung und eine zweite Öffnung in dem Hohlraum, um in geöffneten Zustand für einen Durchgang zu sorgen, und führt die erste Öffnung von dem Hohlraum zu dem Spalt, der in dem geöffneten Zustand zwischen dem Schließelement und dem Absperrelement ausgebildet ist. Ein solches Schließelement kann besonders einfach an einer starren Trennwand befestigt werden.

In noch einer Weiterbildung der bevorzugten Ausführungsform führt die zweite Öffnung von dem Hohlraum zu einem weiteren Spalt, der in dem geöffneten Zustand zwischen dem Schließelement und dem Absperrelement ausgebildet. ein solches Schließelement kann in einem mittigen Bereich besonders einfach an einer starren Trennwand befestigt werden.

In noch einer Weiterbildung der bevorzugten Ausführungsform mündet eine dritte Öffnung in dem Hohlraum. Ein solches Absperrorgan hat mehrere Öffnungszustände und kann als ein Verteiler eingesetzt werden.

In noch einer Weiterbildung der bevorzugten Ausführungsform weisen die Folie und die weitere Folie oder weiteren Folien jeweils selbstklebende Oberflächenbereiche auf den gegenüberliegenden Seiten auf, die jeweils an einer der Elektroden oder einer benachbarten Folie kleben. Ein solches Absperrorgan kann mit geringem Aufwand und somit kostengünstig hergestellt werden.

In noch einer Weiterbildung der bevorzugten Ausführungsform Weisen die Elektroden eine Schicht aus Graphitpulver auf. Eine solche Schicht weist eine hohe Leitfähigkeit auf, lässt sich einfach und kostengünstig herstellen und kann sich leicht ausdehnen, wie erforderlich. Alternativ können auch Kohlenstoffnanoröhren (CNT) als Elektroden verwendet werden.

Die vorliegende Erfindung betrifft ferner ein Verfahren zum Herstellen eines Absperrorgans mit einem Sperrkörper und einem Schließelement, wobei eine Folie aus elektroaktivem Werkstoff und eine weitere Folie aus elektroaktivem Werkstoff um eine Sperrkörper gewickelt werden, wobei auf gegenüberliegenden Seiten der Folie zwei Elektroden flächig angeordnet sind, und wobei eine der zwei Elektroden flächig zwischen der Folie und der weiteren Folie angeordnet ist. Ein solches Absperrorgan lässt sich mit geringem Aufwand fertigen und ist somit kostengünstig. Dadurch dass die Folien mehrfach um den Sperrkörper gewickelt werden, lässt sich die Anpresskraft der Folien an den Sperrkörper erhöhen und lässt sich eine besonders hohe Dichtigkeit des Absperrorgans erreichen.

In einer bevorzugten Ausführungsform wird eine schlauchförmige Folie über den Sperrkörper gezogen, bevor die Folie und die weitere Folie um den Sperrkörper gewickelt werden. Dadurch lässt sich eine noch höhere Dichtigkeit des Absperrorgans erreichen.

### Kurze Beschreibung der Zeichnungen

Im Folgenden wird die Erfindung mit Bezugnahme auf die Zeichnungen näher beschrieben. Es zeigen:
FIG. 1 eine Seitenansicht eines Absperrorgans gemäß einer ersten Ausführungsform;
FIG. 2 eine Längsschnittansicht des Absperrorgans aus FIG. 1 entlang der Linie A-A in einem Schließzustand;
FIG. 3 eine Längsschnittansicht des Absperrorgans aus FIG. 1 entlang der Linie A-A in einem Öffnungszustand;
FIG. 4A eine Querschnittansicht des Absperrorgans aus FIG. 1 entlang der Linie B-B in dem Schließzustand;
FIG. 4B eine Querschnittansicht des Absperrorgans aus FIG. 1 entlang der Linie B-B in dem Öffnungszustand;
FIG. 4C eine Querschnittansicht des Absperrorgans aus FIG. 1 mit einem alternativen Schließelement entlang der Linie B-B in dem Schließzustand;
FIG. 5A eine Längsschnittansicht eines Absperrorgans gemäß einer zweiten Ausführungsform in einem Schließzustand;
FIG. 5B eine Längsschnittansicht des Absperrorgans aus FIG. 5A in einem Öffnungszustand;
FIG. 6A eine Längsschnittansicht eines Absperrorgans gemäß einer dritten Ausführungsform in einem Schließzustand;
FIG. 6B eine Längsschnittansicht des Absperrorgans aus FIG. 6A in einem Öffnungszustand;
FIG. 7A eine Längsschnittansicht eines Absperrorgans gemäß einer vierten Ausführungsform in einem Schließzustand;
FIG. 7B eine Längsschnittansicht des Absperrorgans aus FIG. 7A in einem ersten Öffnungszustand;
FIG. 7C eine Längsschnittansicht des Absperrorgans aus FIG. 7A in einem zweiten Öffnungszustand; und
FIG. 7D eine Längsschnittansicht des Absperrorgans aus FIG. 7A in einem dritten Öffnungszustand.

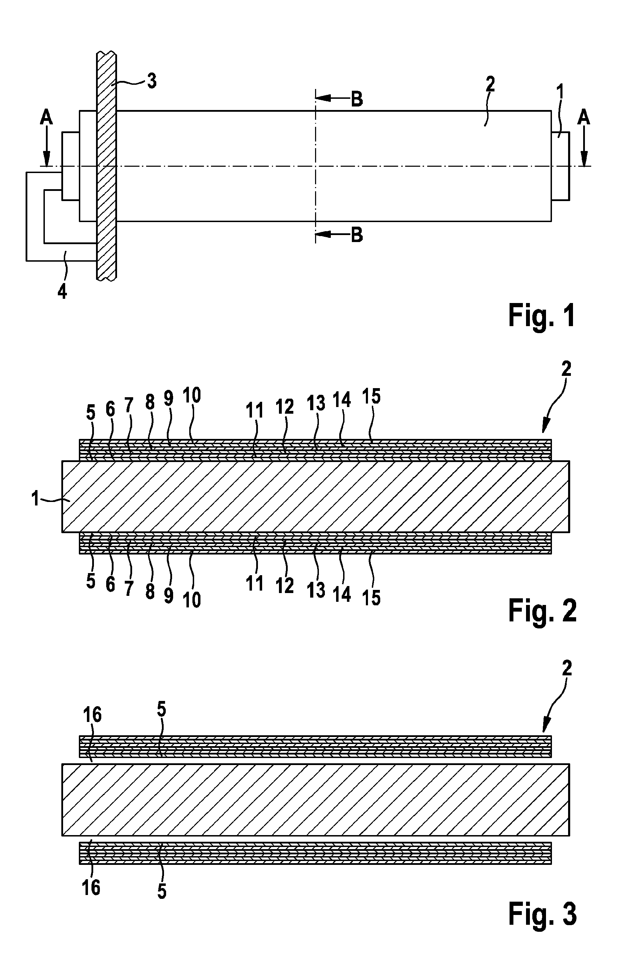

FIG. 1 zeigt eine Seitenansicht eines Absperrorgans gemäß einer ersten Ausführungsform. Das Absperrorgan umfasst einen zylindrischen Sperrkörper 1 und ein hohlzylindrisches Schließelement 2. Der Sperrkörper 1 ist in dem hohlzylindrischen Schließelement 2 aufgenommen. Das Schließelement 2 ist in einer Aussparung einer elastischen Trennwand 3 aufgenommen und vakuumdicht befestigt. Der Sperrkörper 1 ist mit der Trennwand 3 über eine Halterung 4 befestigt, die mit einem Ende des Sperrkörpers 1 verbunden ist. Ein solches Absperrorgan kann für irgendwelche Fluide verwendet werden und ist insbesondere für die Steuerung der Komfortfunktion oder der dynamisch adaptiven Sitzsteifigkeit von Luftkissen in Kraftfahrzeugsitzen oder für Vorsteuerventile in Ventiltrieben auf dem Gebiet der Industrieautomatisierung geeignet.

FIG. 2 zeigt eine Längsschnittansicht des Absperrorgans aus FIG. 1 entlang der Linie A-A in einem Schließzustand. Der Sperrkörper 1 ist als Vollzylinder ausgebildet und besteht in dieser Ausführungsform und den weiteren Ausführungsformen aus Kunststoff, Metall oder Keramik. Der Sperrkörper 1 kann auch eine Elastomerbeschichtung aufweisen. Das Schließelement 2 umfasst mehrere schlauchförmige Folien 5, 6, 7, 8, 9 und 10, welche den Sperrkörper 1 ringförmig umgeben. Die Folien bestehen in dieser Ausführungsform und den weiteren Ausführungsformen aus einem elektroaktiven Polymer, insbesondere einem dielektrischen Elastomer wie Silikon, Fluor-Silikon, Polyurethan, Polybutadien, Polyacryl, Polytetrafluorethylen, P(VDF-TrFE)-Copolymer oder Isopren, haben eine Dicke zwischen 4 µm und 250 µm, vorzugsweise zwischen 4 µm und 100 µm, sind elektrisch isolierend und haben eine hohe Lebensdauer. Die Folien 5, 6, 7, 8, 9 und 10 sind in dieser Ausführungsform und den weiteren Ausführungsformen im Wesentlichen planparallel angeordnet, da sie und die Elektrode zwischen ihnen konstante Dicken haben. Die Folien 5, 6, 7, 8, 9 und 10 können in dieser Ausführungsform und den weiteren Ausführungsformen unter anderen durch ein Spin-Coating-Verfahren oder Sprühverfahren hergestellt werden. Im Schließzustand liegt dabei die innerste Folie in dieser Ausführungsform und den weiteren Ausführungsformen dicht und elastisch vorgespannt an dem Sperrkörper an. Zwischen zwei benachbarten Folien ist jeweils eine Elektrode 11, 12, 13, 14 oder 15 ausgebildet, die in dieser Ausführungsform und den weiteren Ausführungsformen aus einer Graphitpulverschicht besteht. Alternativ können auch Kohlenstoffnanoröhren (CNT) als Elektroden verwendet werden. Selbstklebende Oberflächenbereiche der Folien 5, 6, 7, 8, 9 und 10 haften jeweils an den Elektrode 11, 12, 13, 14 oder 15 und bilden gemeinsam einen Hohlzylinder bzw. Schlauch. Die Folien und Elektroden sind in dieser Ausführungsform und den weiteren Ausführungsformen nicht maßstabsgetreu, sondern für eine bessere Darstellbarkeit übertrieben dick dargestellt. Jede dieser Elektroden wird in dieser Ausführungsform und den weiteren Ausführungsformen durch eine elektrische Leitung (nicht dargestellt) kontaktiert. Diese elektrischen Leitungen können als zwei unterschiedlichen Sammelelektroden und als Durchkontaktierungen ausgebildet sein, wobei benachbarte Elektroden jeweils unterschiedlichen Sammelelektroden kontaktieren. An den gegenüberliegenden Enden des hohlzylindrischen Schließelements kann in dieser Ausführungsform und den weiteren Ausführungsformen zusätzlich eine Isolierung (nicht dargestellt) vorgesehen sein, um die Elektroden auf beiden Seiten elektrisch zu isolieren und eventuell abzudichten. Die Elektroden können alternativ auch nicht bis ganz zu den Rändern der Folien reichen. Die Graphitpulverschicht ist so dünn, dass die Folien für diese Ausführungsform und die weiteren Ausführungsformen jeweils auf gegenüberliegenden Seiten der gleichen Graphitkörner anhaften.

FIG. 3 zeigt eine Längsschnittansicht des Absperrorgans aus FIG. 1 entlang der Linie B-B in einem Öffnungszustand. Eine Längenänderung der Folien 5, 6, 7, 8, 9 und 10 aufgrund ihrer Inkompressibilität ist nicht dargestellt. Die innerste Folie 5 liegt nicht mehr an dem Sperrkörper 1 an, sondern es ist ein ringförmiger Spalt 16 zwischen dem Sperrkörper 1 und der innersten Folie 5 ausgebildet. Das Schließelement 2 wird von dem Schließzustand in den Öffnungszustand gebracht, indem an jeweils zwei benachbarte Elektroden 11 bis 15 entgegen gesetzten Spannungen angelegt werden. Die zwei benachbarten Elektroden 11 bis 15 ziehen sich dann gegenseitig an und drücken die dazwischen liegenden Folien 6, 7, 8 und 9 zusammen. Aufgrund der Inkompressibilität der Folien 6, 7, 8 und 9 verändern sich dann deren Längsabmessungen, so dass sich das hohlzylindrische Schließelement 2 radial ausdehnt. Die innerste Folie 5 und die äußerste Folie 10 dienen zur elektrischen Isolation.

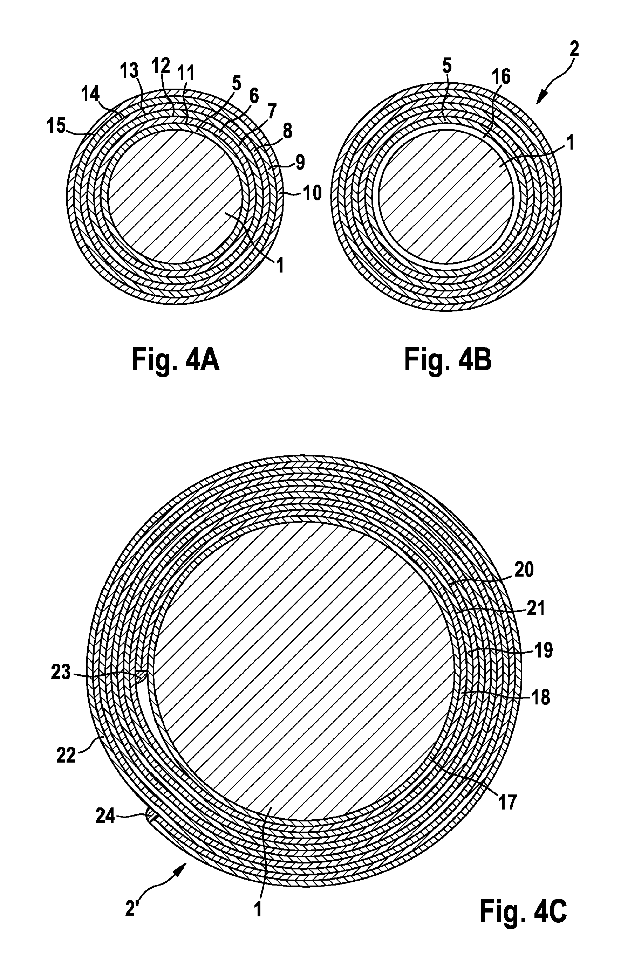

FIG. 4A zeigt eine Querschnittansicht des Absperrorgans aus FIG. 1 entlang der Linie B-B in dem Schließzustand. Die Folien 5, 6, 7, 8, 9, 10 sind ringförmig bzw. schlauchförmig ausgebildet. Zwischen den schlauchförmigen Folien ist jeweils eine ringförmige Elektrode 11, 12, 13, 14 und 15 ausgebildet.

FIG. 4B zeigt eine Querschnittansicht des Absperrorgans aus FIG. 1 entlang der Linie B-B in dem Öffnungszustand. Zwischen der innersten Folie 5 und dem Sperrkörpern 1 ist der ringförmige Spalt 16 ausgebildet.

FIG. 4C zeigt eine Querschnittansicht des Absperrorgans aus FIG. 1 mit einem alternativen Schließelement 2' entlang der Linie B-B in dem Schließzustand. Das alternative Schließelement 2' weist eine innere schlauchförmige Folie 17 aus einem Polymerwerkstoff und zwei weitere spiralförmige angeordnete Folien 18 und 19 auf, die um den Sperrkörper 1 und die innere schlauchförmige Folie 17 aus einem elektroaktiven Polymer gewickelt sind, um das schlauchförmige bzw. hohlzylindrische Schließelement 2' zu bilden. Der Spalte der zwischen den Folien 17 und 18 am Ende der Wicklung ausgebildet ist durch Dichtungen verschlossen, die an den gegenüberliegenden axialen Enden des Schließelements 2' vorgesehen sind. Zwischen der Folie 18 und der Folie 19 ist eine Elektrode 20 ausgebildet. Auf der gegenüberliegenden Seite der Folie 19 ist eine weitere Elektrode 21 ausgebildet. Die Elektrode 21 hört vor einem Oberflächenbereich 22 der Folie 19 auf, so dass die Folie 18 die Elektrode 21 außen vollständig isoliert. An den Enden der Elektroden 20 und 21 ist jeweils eine Isolierung 23, 24 vorgesehen. Selbstklebende Oberflächenbereiche der Folien 18 und 19 haften jeweils an den Elektrode 20, 21 und der schlauchförmigen Folie 17 und bilden gemeinsam einen Hohlzylinder bzw. Schlauch. Werden an die Elektroden 20 und 21 entgegen gesetzte Spannungen angelegt, drücken diese die dazwischen liegenden Folien 18 und 19 zusammen, und das Schließelement 2 dehnt sich radial aus, so dass ein Spalt zwischen dem Sperrkörper 1 und der schlauchförmigen Folie 17 des Schließelements 2' entsteht.

Das Schließelement 2' kann auf besonders einfache Weise hergestellt werden. Zunächst wird die schlauchförmige Folie 17 über den Sperrkörper 1 gezogen. Dann wird eine mehrlagige Struktur aus den Folien 18 und 19 und Elektroden 20 und 21 um den Sperrkörper 1 und die schlauchförmige Folie 17 gewickelt. Ein selbstklebender Bereich der Folie 18 haftet dabei zunächst an der schlauchförmigen Folie 17 an. Sobald die schlauchförmige Folie 18 um 360 Grad um den Sperrkörper gewickelt ist, haftet die selbstklebende Folie 18 an der Elektrode 21 an. Diese Struktur selbst wird durch selbstklebende Oberflächenbereiche der Folien 18 und 19 zusammengehalten.

Die Absperrorgane gemäß einer zweiten, dritten und vierten Ausführungsform weisen jeweils einen zylindrischen Sperrkörper und ein hohlzylindrisches Schließelement auf. Das Schließelement kann mehrere schlauchförmige Folien, wie das Schließelement 2 aus FIG. 4A und FIG. 4B oder eine Schlauchförmige Folie aufweisen, um die zwei weitere Folien gewickelt sind, wie das Schließelement aus FIG. 4C. Es werden im Folgenden nur Längsschnittansichten der Absperrorgane der zweiten, dritten und vierten Ausführungsform dargestellt, welche mehrere schlauchförmige Folien aufweisen. Unterschiedliche Bereiche werden dadurch gebildet, dass Elektroden zwischen den Folien vorgesehen sind oder nicht.

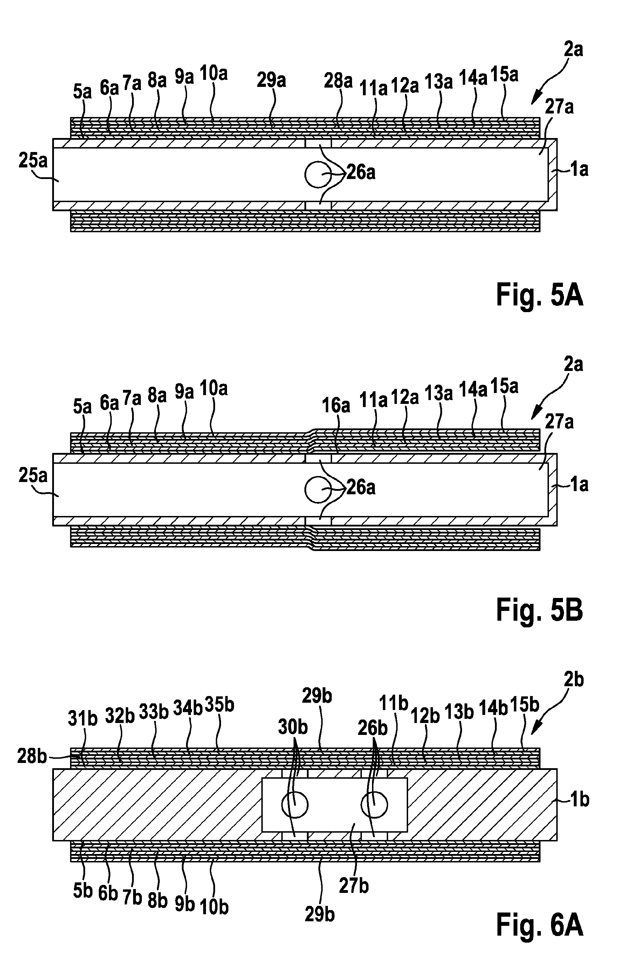

FIG. 5A zeigt eine Längsschnittansicht eines Absperrorgans gemäß einer zweiten Ausführungsform in einem Schließzustand. Der Sperrkörper 1a unterscheidet sich von dem Sperrkörper 1 dadurch, dass er als Hohlzylinder mit einem geschlossenen Ende und einem offenen Ende ausgebildet ist, in dem eine Öffnung 25a ausgebildet ist. Weitere Öffnungen 26a verlaufen an einer Stelle um den Umfang des Sperrkörpers 1a und münden in einem Hohlraum 27a des Sperrkörpers 1a. Elektroden 11a bis 15a sind nun nicht entlang der gesamten Länge des Schließelement 2a ausgebildet, sondern nur in den Bereichen 28a zwischen zwei Folien, während in den Bereichen 29a eines Umfangsabschnitts keine Elektroden ausgebildet sind. Das Absperrorgan kann um die Bereiche 29a herum einfach an starren Trennwänden angebracht werden. Alternativ kann auch eine Halterung in dieser Ausführungsform und den weiteren Ausführungsformen an einem Ende des Sperrkörpers vorgesehen sein.

FIG. 5B zeigt eine Längsschnittansicht des Absperrorgans aus FIG. 5A in einem Öffnungszustand. An zwei benachbarten Elektroden 11a, 12a, 13a, 14a und 15a sind jeweils entgegen gesetzte Spannungen angelegt, so dass sich das Schließelement 2a bei den Bereichen 28a, wo die Elektroden 11a, 12a, 13a, 14a und 15a vorgesehen sind, radial ausgedehnt hat, und sich ein Spalt 16a zwischen der innersten Folie 5a und dem Sperrkörper 2a ausgebildet hat. Es ist somit ein Durchgang durch die Öffnung 25a, den Hohlraum 27a, die Öffnungen 26a und den Spalt 16a vorhanden.

FIG. 6A zeigt eine Längsschnittansicht eines Absperrorgans gemäß einer dritten Ausführungsform in einem Schließzustand. Der Sperrkörper 1b unterscheidet sich von dem Sperrkörper 1 dadurch, dass er einen Hohlraum 27b aufweist. Öffnungen 26b und 30b verlaufen an einer ersten Stelle und an einer zweiten Stelle um den Umfang des Sperrkörpers 1b und münden in dem Hohlraum 27b des Sperrkörpers 1b. Elektroden 11b bis 15b und 31b bis 35b sind nun nicht entlang der gesamten Länge des Schließelement 2b ausgebildet, sondern nur in den Bereichen 28b zwischen zwei Folien an den gegenüberliegenden Enden, während bei den mittleren Bereichen 29b eines Umfangsabschnitts keine Elektroden ausgebildet sind. Jede der Elektroden 11b bis 15b und 31b bis 35b hat einen separaten Anschluss. Das Absperrorgan kann um die Bereiche 29b herum einfach an starren Trennwänden angebracht werden.

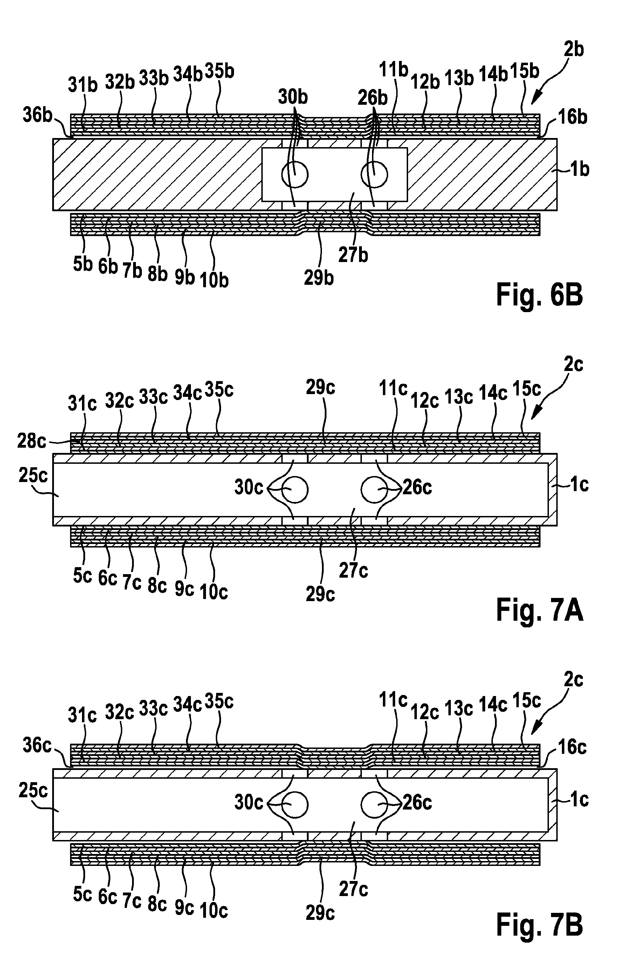

FIG. 6B zeigt eine Längsschnittansicht des Absperrorgans aus FIG. 6A in einem Öffnungszustand. An zwei benachbarten Elektroden 11b, 12b, 13b, 14b, 15b, 31b, 32b, 33b, 34b und 35b sind jeweils entgegen gesetzte Spannungen angelegt, so dass sich das Schließelement 2b bei den Bereichen 28b, wo die Elektroden 11b, 12b, 13b, 14b, 15b, 31b, 32b, 33b, 34b und 35b vorgesehen sind, radial ausgedehnt hat, und sich Spalte 16b und 36b zwischen der innersten Folie 5b und dem Sperrkörper 1b ausgebildet hat. Es ist somit ein Durchgang durch den Spalt 36b, die Öffnung 30b, den Hohlraum 27b, die Öffnungen 26b und den Spalt 16b vorhanden.

FIG. 7A zeigt eine Längsschnittansicht eines Absperrorgans gemäß einer vierten Ausführungsform in einem Schließzustand. Der Sperrkörper 1c unterscheidet sich von dem Sperrkörper 1 dadurch, dass er als Hohlzylinder mit einem geschlossenen Ende und einem offenen Ende ausgebildet ist, in dem eine Öffnung 25c ausgebildet ist. Weitere Öffnungen 26c und 30c verlaufen an einer ersten Stelle und an einer zweiten Stelle um den Umfang des Sperrkörpers 1c und münden in einem Hohlraum 27c des Sperrkörpers 1c. Elektroden 11c bis 15c und 31c bis 35c sind nun nicht entlang der gesamten Länge des Schließelement 2c ausgebildet, sondern nur in den Bereichen 28c zwischen zwei Folien an den gegenüberliegenden Enden, während bei den mittleren Bereichen 29c eines Umfangsabschnitts keine Elektroden ausgebildet sind. Jede der Elektroden 11c bis 15c und 31c bis 35c hat einen separaten Anschluss. Das Absperrorgan kann um die Bereiche 29c herum einfach an starren Trennwänden angebracht werden.

FIG. 7B zeigt eine Längsschnittansicht des Absperrorgans aus FIG. 7A in einem ersten Öffnungszustand. An zwei benachbarten Elektroden 11c, 12c, 13c, 14c, 15c, 31c, 32c, 33c, 34c und 35c sind jeweils entgegen gesetzte Spannungen angelegt, so dass sich das Schließelement 2c bei den Bereichen 28c, wo die Elektroden 11c, 12c, 13c, 14c, 15c, 31c, 32c, 33c, 34c und 35c vorgesehen sind, radial ausgedehnt hat, und sich Spalte 16c und 36c zwischen der innersten Folie 5b und dem Sperrkörper 1b ausgebildet hat. Es ist somit ein Durchgang durch die Öffnung 25c, den Hohlraum 27c, die Öffnungen 26c und den Spalt 16c und ein weiterer Durchgang durch die Öffnung 25c, den Hohlraum 27c, die Öffnungen 30c und den Spalt 36c vorhanden.

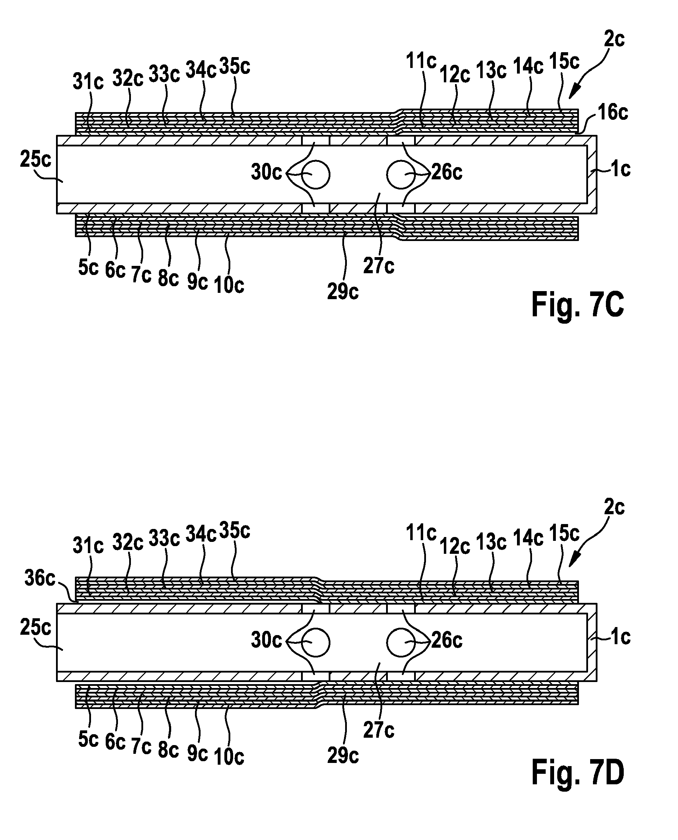

FIG. 7C zeigt eine Längsschnittansicht des Absperrorgans aus FIG. 7A in einem ersten Öffnungszustand. An zwei benachbarten Elektroden 11c, 12c, 13c, 14c und 15c sind jeweils entgegen gesetzte Spannungen angelegt, so dass sich das Schließelement 2c bei den Bereichen 28c, wo die Elektroden 11c, 12c, 13c, 14c und 15c vorgesehen sind, radial ausgedehnt hat, und sich der Spalt 16c zwischen der innersten Folie 5b und dem Sperrkörper 1b ausgebildet hat. Es ist somit ein Durchgang durch die Öffnung 25c, den Hohlraum 27c, die Öffnungen 26c und den Spalt 16c vorhanden.

FIG. 7D zeigt eine Längsschnittansicht des Absperrorgans aus FIG. 7A in einem ersten Öffnungszustand. An zwei benachbarten Elektroden 31c, 32c, 33c, 34c und 35c sind jeweils entgegen gesetzte Spannungen angelegt, so dass sich das Schließelement 2c bei den Bereich 28c, wo die Elektroden 31c, 32c, 33c, 34c und 35c vorgesehen sind, radial ausgedehnt hat, und sich ein Spalt 36c zwischen der innersten Folie 5b und dem Sperrkörper 1b ausgebildet hat. Es ist somit ein Durchgang durch die Öffnung 25c, den Hohlraum 27c, die Öffnungen 30c und den Spalt 36c vorhanden.

## Patentansprüche

1. Absperrorgan mit einem Sperrkörper (1, 1a, 1b, 1c) und einem Schließelement (2, 2', 2a, 2b, 2c), wobei das Schließelement (2, 2', 2a, 2b, 2c) einen elektroaktiven Werkstoff (6, 6a, 6b, 6c, 19) und zwei Elektroden (11, 12, 11a, 12a, 11b, 12b, 11c, 12c, 20, 21) umfasst, um den elektroaktiven Werkstoff durch Anlegen geeigneter Spannungen zwischen einem Schließzustand und einem Öffnungszustand zu verformen, **dadurch gekennzeichnet, dass** das Schließelement (2, 2', 2a, 2b, 2c) zumindest einen Teil des Umfangs des Sperrkörpers (1, 1a, 1b, 1c) umgibt, dass in dem Öffnungszustand ein Spalt (16, 16a, 16b, 16c, 36b, 36c) zwischen dem Sperrkörper (1, 1a, 1b, 1c) und dem Schließelement (2, 2', 2a, 2b, 2c) ausgebildet ist, und dass in dem Schließzustand der Spalt (16, 16a, 16b, 16c, 36b, 36c) zwischen dem Sperrkörper (1, 1a, 1b, 1c) und dem Schließelement (2, 2', 2a, 2b, 2c) verschlossen ist.

2. Absperrorgan nach Anspruch 1, **dadurch gekennzeichnet, dass** der zumindest eine Teil des Umfangs des Sperrkörpers (1, 1a, 1b, 1c) ein elliptischer, vorzugsweise kreisförmiger Umfangsabschnitt ist.

3. Absperrorgan nach Anspruch 2, **dadurch gekennzeichnet, dass** der elektroaktive Werkstoff als eine Folie (6, 6a, 6b, 6c, 19) mit einer Dicke zwischen 4 µm und 250 µm, vorzugsweise zwischen 4 µm und 100 µm, ausgebildet ist, und dass die zwei Elektroden (11, 12, 11a, 12a, 11b, 12b, 11c, 12c, 20, 21) auf gegenüberliegenden Seiten der Folie (6, 6a, 6b, 6c, 19) flächig angeordnet sind.

4. Absperrorgan nach Anspruch 3, **dadurch gekennzeichnet, dass** das Schließelement (2') eine weitere Folie (18) aus elektroaktivem Werkstoff aufweist, dass eine der zwei Elektroden (21) flächig zwischen der Folie (19) und der weitern Folie (18) angeordnet ist, dass die Folie (19) und die weitere Folie (18) um den Abschnitt des Sperrkörpers (1) gewickelt sind, und dass die Folie (19) und die weitere Folie (18) einen Schlauch bilden, in dem der Abschnitt des Sperrkörpers (1) aufgenommen ist.

5. Absperrorgan nach Anspruch 4, **dadurch gekennzeichnet, dass** das Schließelement (2') eine schlauchförmige Folie (17) umfasst, welche den Sperrkörper (1) umgibt.

6. Absperrorgan nach Anspruch 3, **dadurch gekennzeichnet, dass** das Schließelement (2, 2a, 2b, 2c) mehrere weitere Folien (5, 6, 7, 8, 9, 10, 5a, 6a, 7a, 8a, 9a, 10a, 5b, 6b, 7b, 8b, 9b, 10b, 5c, 6c, 7c, 8c, 9c, 10c) aus elektroaktivem Werkstoff aufweist, dass zwischen benachbarten Folien (5, 6, 7, 8, 9, 10, 5a, 6a, 7a, 8a, 9a, 10a, 5b, 6b, 7b, 8b, 9b, 10b, 5c, 6c, 7c, 8c, 9c, 10c) jeweils eine Elektrode (11, 12, 13, 14, 15, 11a, 12a, 13a, 14a, 15a, 11b, 12b, 13b, 14b, 15b, 11c, 12c, 13c, 14c, 15c, 31b, 32b, 33b, 34b, 35b, 31c, 32c, 33c, 34c, 35c) flächig angeordnet ist, und dass die Folie (6, 6a, 6b, 6c, 19) und die weitere Folie (5, 7, 8, 9, 10, 5a, 7a, 8a, 9a, 10a, 5b, 7b, 8b, 9b, 10b, 5c, 7c, 8c, 9c, 10c) schlauchförmig ausgebildet sind und einen mehrlagigen Schlauch bilden, in dem der Abschnitt des Schließelements (2, 2', 2a, 2b, 2c) aufgenommen ist.

7. Absperrorgan nach einem der Ansprüche 3 bis 6, **dadurch gekennzeichnet, dass** das Schließelement (2a, 2b, 2c) einen Umfangsabschnitt aufweist, in dem keine Elektrode (11a, 12a, 13a, 14a, 15a, 11b, 12b, 13b, 14b, 15b, 11c, 12c, 13c, 14c, 15c, 31b, 32b, 33b, 34b, 35b, 31c, 32c, 33c, 34c, 35c) ausgebildet ist, dass der Sperrkörper (1a, 1b, 1c) einen Hohlraum (27a, 27b, 27c) aufweist, dass eine erste Öffnung (26a, 26b. 26c) und eine zweite Öffnung (25a, 30b, 30c) in dem Hohlraum (27a, 27b, 27c) münden, um in geöffneten Zustand für einen Durchgang zu sorgen, und dass die erste Öffnung (26a, 26b. 26c) von dem Hohlraum (27a, 27b, 27c) zu dem Spalt (16, 16a, 16b, 16c) führt, der in dem geöffneten Zustand zwischen dem Schließelement (2', 2a, 2b, 2c) und dem Sperrkörper (1, 1a, 1b, 1c) ausgebildet ist.

8. Absperrorgan nach Anspruch 7, **dadurch gekennzeichnet, dass** die zweite Öffnung (25a, 30b, 30c) von dem Hohlraum (25a, 30b, 30c) zu einem weiteren Spalt (36b, 36c) führt, der in dem geöffneten Zustand zwischen dem Schließelement (2b, 2c) und dem Sperrkörper (1b, 1c) ausgebildet.

9. Absperrorgan nach Anspruch 8, **dadurch gekennzeichnet, dass** eine dritte Öffnung (25c) in dem Hohlraum (27c) mündet.

10. Absperrorgan einem der Ansprüche 4 bis 9, **dadurch gekennzeichnet, dass** die Folie (6, 6a, 6b, 6c, 19) und die weitere Folie (18) oder weiteren Folien (5, 6, 7, 8, 9, 10, 5a, 6a, 7a, 8a, 9a, 10a, 5b, 6b, 7b, 8b, 9b, 10b, 5c, 6c, 7c, 8c, 9c, 10c, 17, 19) jeweils selbstklebende Oberflächenbereiche auf den gegenüberliegenden Seiten aufweisen, die jeweils an einer der Elektroden (11a, 12a, 13a, 14a, 15a, 11b, 12b, 13b, 14b, 15b, 11c, 12c, 13c, 14c, 15c, 31b, 32b, 33b, 34b, 35b, 31c, 32c, 33c, 34c, 35c) oder einer benachbarten Folie (5, 6, 7, 8, 9, 10, 5a, 6a, 7a, 8a, 9a, 10a, 5b, 6b, 7b, 8b, 9b, 10b, 5c, 6c, 7c, 8c, 9c, 10c, 17, 19, 18) kleben.

11. Absperrorgan nach einem der Ansprüche 3 bis 10, **dadurch gekennzeichnet, dass** die Elektroden (11, 12, 13, 14, 15, 11a, 12a, 13a, 14a, 15a, 11b, 12b, 13b, 14b, 15b, 11c, 12c, 13c, 14c, 15c, 20, 21, 31b, 32b, 33b, 34b, 35b, 31c, 32c, 33c, 34c, 35c) jeweils eine Schicht aus Graphitpulver oder Kohlenstoffnanoröhren aufweisen.

12. Verfahren zum Herstellen eines Absperrorgans mit einem Sperrkörper (1) und einem Schließelement (2'), **dadurch gekennzeichnet, dass** eine Folie (19) aus elektroaktivem Werkstoff und eine weitere Folie (18) aus elektroaktivem Werkstoff um eine Sperrkörper (1) gewickelt werden, wobei auf gegenüberliegenden Seiten der Folie (19) zwei Elektroden (20, 21) flächig angeordnet sind, und wobei eine der zwei Elektroden (20, 21) flächig zwischen der Folie (19) und der weiteren Folie (18) angeordnet ist.

13. Verfahren zum Herstellen eines Absperrorgans nach Anspruch 12, **dadurch gekennzeichnet, dass** eine schlauchförmige Folie (17) über den Sperrkörper (1) gezogen wird, bevor die Folie (19) und die weitere Folie (18) um den Sperrkörper (1) gewickelt werden.
